# EUROPEAN PATENT APPLICATION

(11) **EP 1 458 030 A2**
(43) Date of publication of application: **15.09.2004**
(21) Application number: 04250862.2
(22) Date of filing: 18.02.2004
(51) Int. Cl.: H01L 29/49, H01L 29/45

(54) **Novel and conductive elements for thin film transistors used in a flat panel display**

(30) Priority: 12.03.2003 KR 2003015357
(71) Applicant: Samsung SDI Co., Ltd., Suwon-si, Gyeonggi-do (KR)
(72) Inventor: Kim, Tae-Sung, Incheon-si (KR); Yoo, Kyung-Jin, 208-1401 Hyundai 2cha Apt, Gyeonggi-do (KR)
(74) Representative: Greene, Simon Kenneth

(57) **Abstract**

A novel design for an electrode for a thin film transistor. The novel design allows for formation of a normal conductive channel between a source electrode and a drain electrode even after a heat treatment process, and a flat panel display including the thin film transistor. The thin film transistor includes a source electrode, a drain electrode, a gate electrode, and a semiconductor layer, wherein at least one of the source electrode, the drain electrode, and the gate electrode includes an aluminum alloy layer, and titanium layers are formed on both surfaces of the aluminum alloy layer. The electrodes are preferably absent any pure aluminum as pure aluminum can diffuse into the semiconductor layer causing a defect region and preventing a conductive channel from forming in the thin film transistor.

## Description

The present invention relates to a flat panel display thin film transistors. More particularly, the present invention relates to a novel structure for electrodes of the thin film transistors that do not degrade the semiconductor material of the thin film transistors in the display.

A thin film transistor (hereinafter TFT) is a device of which a source electrode and a drain electrode can be electrically connected through a channel formed in a semiconductor layer which physically connects the source and drain electrodes according to a voltage applied to a gate electrode. The TFT is mainly used in an active matrix flat panel display such as an electroluminescent display and a liquid crystal display. The TFT serves to independently drive sub-pixels in a flat panel display.

A source electrode and a gate electrode formed on a TFT panel of a flat panel display are connected to driving circuits arranged on sides of the flat panel display through conductive lines. Generally, the source electrode, the drain electrode and the conductive lines electrically connected to the source and drain electrodes are at the same time formed with the same structure using the same material for the sake of simplifying a manufacturing process. Hereinafter, the source electrode, the drain electrode, and the conductive lines electrically connected thereto are simply referred to as "S/D electrodes and lead lines".

The S/D electrodes and lead lines may be made of a chromium (Cr) based metal or a molybdenum (Mo) based metal such as Mo and MoW. However, due to a relatively high resistance, these metals are relatively impractical for forming the S/D electrodes and lead lines for use in a large flat panel display. Recently, attention has been paid to aluminum (Al) as a material for the S/D electrodes and lead lines. However, use of pure Al has a problem in that the aluminum diffuses toward and into a semiconductor layer during a heat treatment process that generally occurs subsequent to formation of the source electrode and the drain electrode. When the aluminum diffuses into the semiconductor layer, the TFT does not function properly.

These problems may worsen by a heat treatment process subsequent to formation of a metal electrode, and conductive lines electrically connected thereto. For example, the contact annealing process after source and drain metal sputtering is necessary in TFT fabrication, and the temperature needed to anneal can be higher than 300°C. When pure aluminum is used in the source and the drain electrodes and a high temperature anneal follows electrode formation, aluminum can diffuse into the semiconductor layer of a TFT and pose a negative effect on the electrical characteristics of the TFT.

U.S. Patent Application Publication No. 2002/0085157 to Tanaka *et al* (hereinafter Tanaka '157) discloses electrodes made of Al. Each of the electrodes has a structure of titanium nitride (TiN)/Al, TiN/Ti/Al, or TiN/Al/Ti. - Advantages of such a structure include reduction of an electrical connection resistance between the electrodes and terminals connected to the electrodes and suppression of generation of Al hillocks often formed during a heat treatment process subsequent to the formation of the electrodes. However, this Tanaka '157 fails to discuss the existence of and a solution to the problem of aluminum from a pure aluminum electrode from diffusing into a semiconductor layer of a transistor during a heat treatment process.

Furthermore, in a case where the conductive lines which are connected to the source and drain electrodes have a three-layer structure of Ti/pure Al/Ti, TiAl₃ may be generated at an interface between the pure Al layer and the Ti layer by a heat treatment process. The TiAl₃ may increase the resistance of the conductive lines. For this reason, in a case where a flat panel display has a large size or its pixels have small sizes, a voltage drop between driving circuits and the pixels may increase when TiAl₃ is formed. Thus, the formation of TiAl₃ causes the response speed of the pixels to decrease and causes a non-uniform distribution of an image in a large display.

In a first aspect, there is provided a thin film transistor, comprising a source electrode, a drain electrode, a gate electrode and a semiconductor layer, wherein one of the source electrode, the drain electrode, and the gate electrode comprises an aluminum alloy layer disposed between a pair of titanium layers.

In a second aspect, there is provided a flat panel display, comprising: a substrate; a first plurality of thin film transistors formed on a surface of the substrate, the first plurality of thin film transistors comprising first source electrodes, first drain electrodes, first gate electrodes, and semiconductor layers; a plurality of first conductive lines electrically connected to the first source electrodes; and a plurality of second conductive lines electrically connected to the first gate electrodes; a second plurality of thin film transistors, wherein the first drain electrodes of the first plurality of thin film transistors are electrically connected to gate electrodes of the second plurality of thin film transistors, wherein one of the first source electrodes, the first drain electrodes, the first gate electrodes, the plurality of first conductive lines, and the plurality of second conductive lines comprises an aluminum alloy layer and a titanium layer formed on one surface of the aluminum alloy layer.

In a third aspect, there is provided a thin film transistor (TFT), comprising: a source electrode, a gate electrode and a drain electrode; and a semiconductor layer between the source electrode and the drain electrode, wherein one of said source electrode and said drain electrode contain an aluminum alloy layer and not a pure aluminum layer.

In a further aspect there is provided an electrode structure where aluminum is used but aluminum is not used in pure form. Instead, an alloy of aluminum is used in the electrodes. The aluminum alloy layer may contain about 0.1 to 5 wt% of at least one element selected from silicon, copper, neodymiumm, platinum, and nickel. The reason why an aluminum alloy and not pure aluminum should be used is because after being subject to a heat treatment, aluminum from a pure aluminum layer will diffuse into the semiconductor layer and corrupt the electrical properties of the TFT. By using an aluminum alloy and not pure aluminum in the electrode structure, the diffusion of aluminum into the semiconductor layer during a heat treatment is prevented.

Other features of the electrode structure may be as follows. To prevent the formation of hillocks in a heat treatment, the aluminum alloy layer may be bounded by titanium. To prevent the formation of highly resistive TiAl₃ during heat treatment, a diffusion prevention layer may be interposed between the aluminum alloy layer and the titanium layer. Preferably, the diffusion prevention layer is TiN or titanium nitride. Optimum TiN thickness is 300Å. The TiN layer may have 5 to 85 wt% of nitrogen.

The present invention may provide an improved design for S/D electrodes and lead lines for TFT's used in a flat panel display.

The present invention may provide a design for electrodes in a TFT that prevent aluminum from diffusing into a semiconductor layer during a heat treatment.

The present invention may provide a novel design for electrodes in a TFT that have a low resistivity and thus result in uniform luminance even when the display size is very large.

The present invention may provide a design for electrodes in a TFT that does not result in a structure where the electrode material reacts with the semiconductive material of the TFT when subject to heat treatment.

A more complete appreciation of the invention, and many of the attendant advantages thereof, will be readily apparent as the same becomes better understood by reference to the following detailed description when considered in conjunction with the accompanying drawings in which like reference symbols indicate the same or similar components, wherein:
FIG. 1 is a circuit view of a TFT panel;
FIG. 2 is a partial plan view of a TFT panel;
FIG. 3 is a sectional view of an electroluminescent display having a TFT;
FIG. 4 is a sectional view of a liquid crystal display having a TFT;
FIG. 5 is a sectional view of a source and drain electrodes in a TFT;
FIG. 6 is a top view of a TFT of FIG. 5 after heat treatment;
FIG. 7 is a sectional view of a source or drain electrode in a thin film transistor (TFT) according to one embodiment of the present invention;
FIG. 8 is a sectional view of a TFT after heat treatment according to the present invention using the electrodes illustrated in FIG. 7;
FIG. 9 is a top view of the TFT of FIG. 8 after heat treatment; and
FIG. 10 is a sectional view of a TFT after heat treatment according to another embodiment of the present invention.

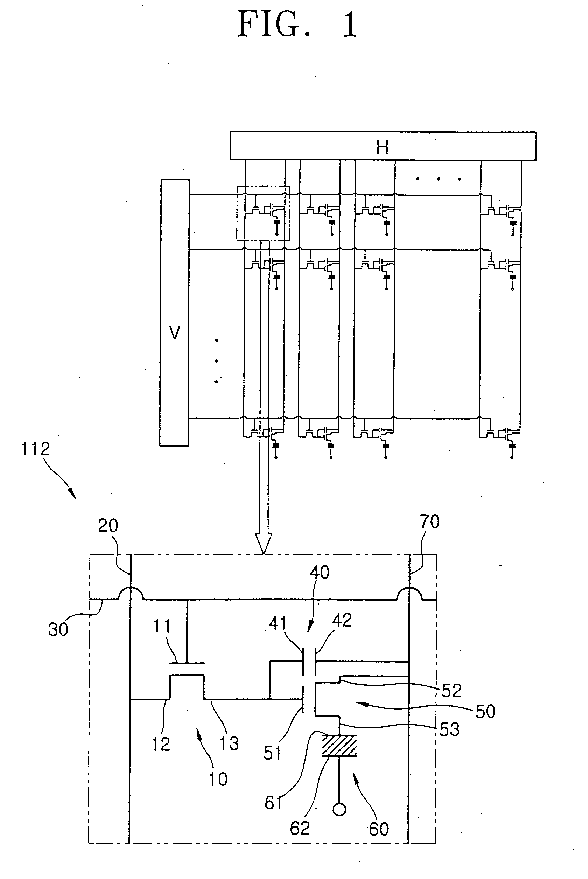

Turning now to the figures, FIG. 1 illustrates a circuit 112 for a flat panel display having a thin film transistors (TFT's) 10 and 50. The circuit 112 includes a first TFT 10, a second TFT 50, a storage capacitor 40, and a light emission unit 60. A first source electrode 12 in the first TFT 10 is connected to a horizontal driving circuit H through a first conductive line 20 and a first gate electrode 11 in the first TFT 10 is connected to a vertical driving circuit V through a second conductive line 30. A first drain electrode 13 in the first TFT 10 is connected to a first capacitor electrode 41 of the storage capacitor 40 and to a second gate electrode 51 of the second TFT 50. A second capacitor electrode 42 of the storage capacitor 40 and a second source electrode 52 of the second TFT 50 are connected to a third conductive line 70. A second drain electrode 53 of the second TFT 50 is connected to a first pixel electrode 61 of the light emission unit 60. A second pixel electrode 62 of the light emission unit 60 is arranged to be opposite to the first pixel electrode 61 and spaced a predetermined gap apart from the first pixel electrode 61. Between the second pixel electrode 62 and the first pixel electrode 61 is an active layer. The active layer may be an organic material layer, an inorganic material layer, or a liquid crystal layer. This active layer is arranged between the first pixel electrode 61 and second pixel electrode 62 of the light emission unit 60 according to one of the various types of flat panel displays.

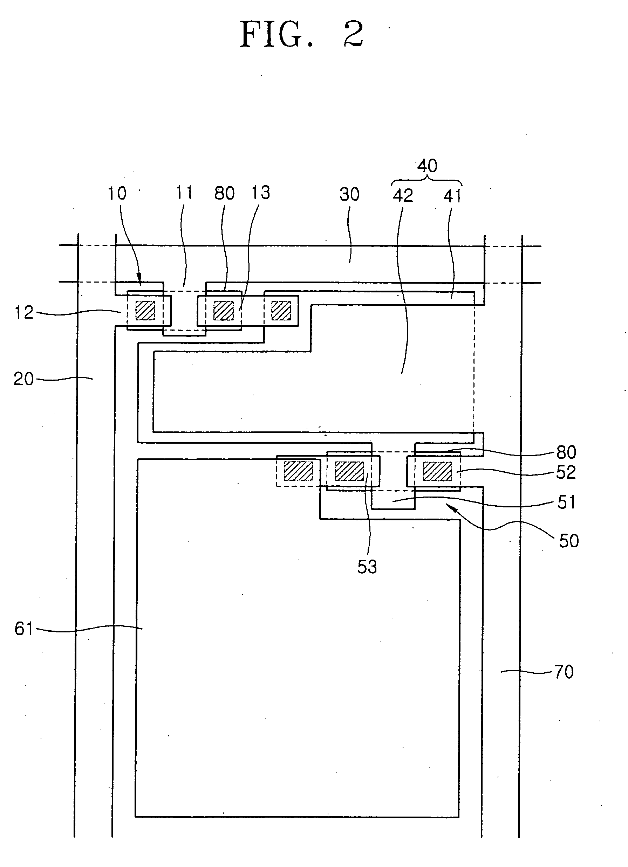

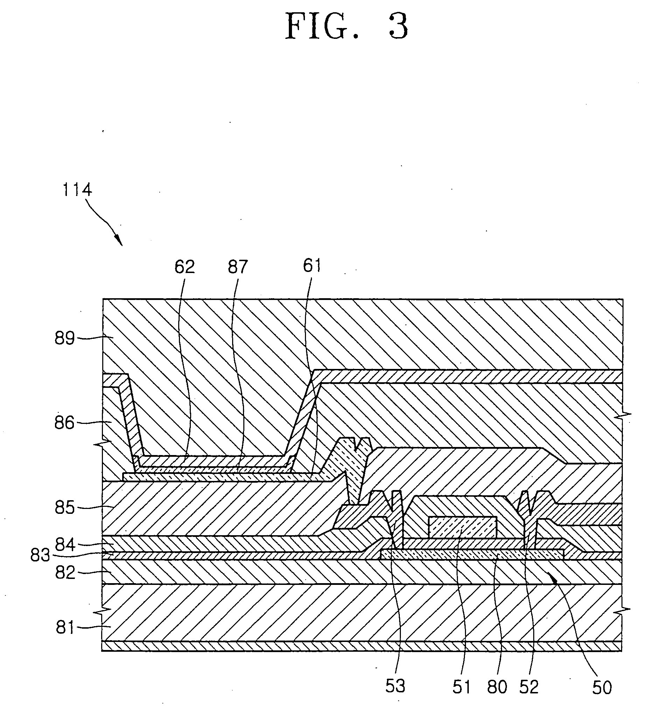

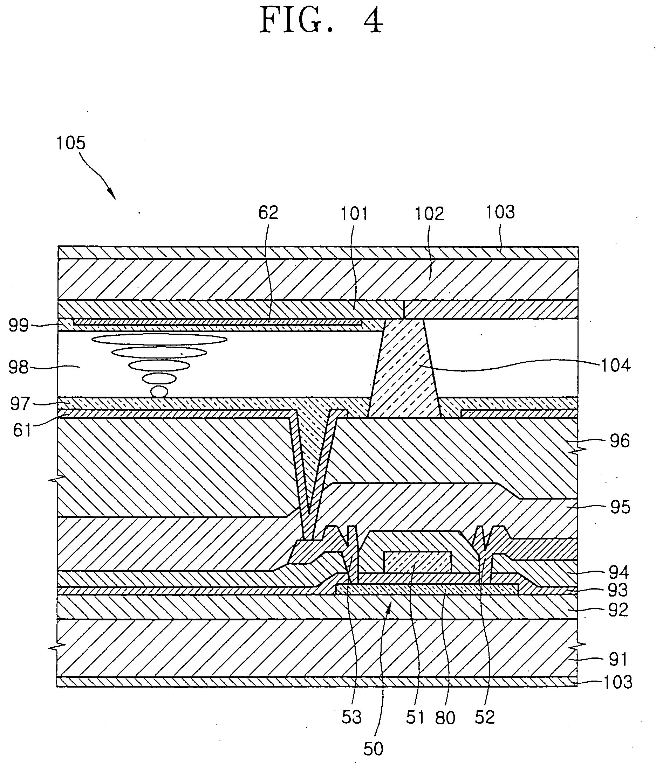

Turning now to FIG. 2, FIG. 2 illustrates a driving unit (one of red component, blue component, and green component that constitute one pixel) of a flat panel display provided with the first TFT 10 and the second TFT 50. FIG. 2 is a schematic plan view illustrating a physical structure of the circuit 112 illustrated in FIG. 1. For the sake of simplicity, only conductive constitutional elements are illustrated in FIG. 2. Therefore, nonconductive constitutional elements such as a substrate, a buffer layer, various types of insulating layers, a planarization layer, a light emission layer, a liquid crystal layer, a second pixel electrode, a polarization layer, an orientation layer, and a color filter layer are omitted. These nonconductive constitutional elements are instead illustrated in FIGS. 3 and 4. Only constitutional elements positioned at regions represented by oblique (or slanted) lines shown in FIG. 2 are electrically connected to each other. Other regions in FIG. 2 that are not represented by oblique lines are electrically insluated.

When a voltage is applied to the first gate electrode 11, a conductive channel is formed in a semiconductor layer 80 that connects the first source electrode 12 to the first drain electrode 13. At this time, when charge is supplied to the first source electrode 12 through the first conductive line 20, the charge moves into the first drain electrode 13. Another charge is supplied into the second source electrode 52 through the third conductive line 70. Luminance of the driving unit is determined according to the charge supplied into the second source electrode 52. When the charge of the first drain electrode 13 is supplied to the second gate electrode 51, the charge of the second source electrode 52 moves into the second drain electrode 53, thereby driving the first pixel electrode 61 of the light emission unit 60. The storage capacitor 40 serves to maintain a driving operation of the first pixel electrode 61 or to increase a driving speed. For reference, the first TFT 10 and the second TFT 50 have a similar section structure, but are different in adjoining constitutional elements.

An electroluminescent display 114 illustrated in FIG. 3 includes a TFT panel, a light emission layer 87, and a second pixel electrode 62. The TFT panel includes a substrate 81, a TFT 50, a first conductive line 20, a second conductive line 30, and a first pixel electrode 61. In the case of a rear emission type electroluminescent display, the substrate 81 may be made of a transparent material, for example glass, and the second pixel electrode 62 may be made of a metal material with good reflectivity. On the other hand, in the case of a front emission type electroluminescent display, the second pixel electrode 62 may be made of a transparent conductive material, for example, indium tin oxide (ITO), and the first pixel electrode 61 may be made of a metal material with good reflectivity.

A buffer layer 82 is formed on the whole surface of the substrate 81. A semiconductor layer 80 is formed to a predetermined pattern on the buffer layer 82. A first insulating layer 83 is formed on the semiconductor layer 80 and on the remaining exposed surface of the buffer layer 82 where the semiconductor layer 80 is not formed. A second gate electrode 51 is formed to a predetermined pattern on the first insulating layer 83. A second insulating layer 84 is formed on the second gate electrode 51 and the remaining exposed surface of the first insulating layer 83 on where the second gate electrode 51 is not formed. After the formation of the second insulating layer 84, the first and second insulating layers 83 and 84 respectively are subjected to etching such as dry etching to expose portions of the semiconductor layer 80. The exposed portions of the semiconductor layer 80 are connected to a second source electrode 52 and a second drain electrode 53 that are formed to a predetermined pattern. After the formation of the second source and drain electrodes 52 and 53 respectively, a third insulating layer 85 is formed thereon. A portion of the third insulating layer 85 is etched to electrically connect the second drain electrode 53 and the first pixel electrode 61. After the formation of the first pixel electrode 61 on the third insulating layer 85, a planarization layer 86 is formed. The portion of the planarization layer 86 corresponding to the first pixel electrode 61 is etched. Then, the light emission layer 87 is formed on the first pixel electrode 61 and the second pixel electrode 62 is formed on the light emission layer 87. In addition, encapsulation layer 89 is formed over second pixel electrode 62.

The TFT 50 made up of the second source electrode 52, the second drain electrode 53, the second gate electrode 51 and the semiconductor layer 80. The second source electrode 52 and the second drain electrode 53 are arranged on the same horizontal plane and are separated from each other by a predetermined gap. The second source electrode 52 and the second drain electrode 53 are each physically connected to the semiconductor layer 80. The second gate electrode 51 is electrically insulated from the second source electrode 52, the second drain electrode 53 and the semiconductor layer 80. The second gate electrode 51 is positioned above the semiconductor layer 80 and between the second source electrode 52 and the second drain electrode 53. Meanwhile, generally, a TFT is divided into a staggered type, an inverted staggered type, a coplanar type, and an inverted coplanar type according to the arrangements of the above electrodes and the semiconductor layer 80. A coplanar type is illustrated in this embodiment of the present invention, but the present invention is not limited thereto.

The TFT 50 of FIG. 3 corresponds to the second TFT 50 illustrated in FIG. 2. In this case, the second source electrode 52 is connected to the third conductive line 70, the second gate electrode 51 is connected to the first drain electrode 13 of the first TFT 10, the second drain electrode 53 is connected to the first pixel electrode 61 of light emitting unit 60, the first source electrode 12 of the first TFT 10 is connected to the first conductive line 20, and the first gate electrode 11 is connected to the second conductive line 30. According to this embodiment of the present invention, the first conductive line 20 corresponds to a data line for transmitting data and the second conductive line 30 corresponds to a scan line.

The structure of an electroluminescent display 114 will now be described in detail with reference to FIG. 3. As illustrated in FIG. 3, an electroluminescent display 114 includes the first pixel electrode 61, the light emission layer 87 formed on the first pixel electrode 61, and the second pixel electrode 62 formed on the light emission layer 87. The electroluminescent display 114 can be divided into organic and inorganic electroluminescent displays. With respect to an organic electroluminescent display, the light emission layer 87 is made up of an electron transport layer, a light emission material layer, and a hole transport layer. With respect to an inorganic electroluminescent display, insulating layers are interposed between the first pixel electrode 61 and the light emission layer 87 and between the second pixel electrode 62 and the light emission layer 87.

The light emission material layer 87 of an organic electroluminescent display is made of an organic material, for example, phthalocyanine such as copper phthalocyanine (CuPc), N,N'-di(naphthalene- 1-yl)-N,N'-diphenyl benzidine (NPB), tris-8-hydroxyquinoline aluminium (Alq3) or the like. When charge is supplied to the first pixel electrode 61 and the second pixel electrode 62, holes and electrons recombine with each other to generate excitons. When the excitons are changed from an excited state to a ground state, the light emission material layer 87 emits light.

Regarding an inorganic electroluminescent display, an inorganic material layer between the insulating layers positioned at inner sides of the first pixel electrode 61 and second pixel electrode 62 emits light. An inorganic material for the inorganic material layer may be metal sulfide such as ZnS, SrS, and CsS. Recently, alkaline earth-based calcium sulfide such as CaCa₂S₄ and SrCa₂S₄, and metal oxide are also used. Transition metal such as Mn, Ce, Tb, Eu, Tm, Er, Pr, and Pb and alkaline rare earth metal may be used as light emitting core atoms that form the light emission layer 87 together with the above inorganic material. When a voltage is applied between the first pixel electrode 61 and second pixel electrode 62, electrons are accelerated and collide with the light emitting core atoms. At this time, electrons of the light emitting core atoms are excited to a higher energy level and then fall back to a ground state. Accordingly, the inorganic material layer emits light.

Turning now to FIG. 4, FIG. 4 illustrates a liquid crystal display 105. A liquid crystal display and an electroluminescent display are similar to each other in terms of the structure of a TFT panel, but are different in adjoining constitutional elements. Hereinafter, only adjoining constitutional elements of the TFT panel in a liquid crystal display will be described.

The liquid crystal display 105 includes a TFT panel, a first orientation layer 97, a second substrate 102, a second pixel electrode 62, a second orientation layer 99, a liquid crystal layer 98, and a polarization layer 103. The TFT panel comprises a first substrate 91, a TFT 50, a first conductive line, a second conductive line, and a first pixel electrode 61. The first substrate 91 corresponds to the substrate of an electroluminescent display.

The first substrate 91 and the second substrate 102 are separately manufactured. A color filter layer 101 is formed on the lower surface of the second substrate 102. The second pixel electrode 62 is formed on the lower surface of the color filter layer 101. The first orientation layer 97 and the second orientation layer 99 are formed on the upper surface of the first pixel electrode 61 and the lower surface of the second pixel electrode 62, respectively. The first and second orientation layers 97 and 99 serve to allow for a proper orientation of a liquid crystal of the liquid crystal layer 98 interposed therebetween. The polarization layer 103 is formed on each of the outer surfaces of the first and second substrates 91 and 102 respectively. A spacer 104 is used to maintain a gap between the first substrate 91 and the second substrates 102. Reference numerals 92, 93, 94, 95 and 96 in FIG. 4 represent a buffer layer, a first insulating layer, a second insulating layer, a third insulating layer and a planarization layer respectively.

A liquid crystal display allows light to pass through or be blocked according to the arrangement of a liquid crystal. The arrangement of the liquid crystal is determined by an electric potential difference between the first and second pixel electrodes. Light that has passed through the liquid crystal layer exhibits a color of the color filter layer 101, thereby displaying an image.

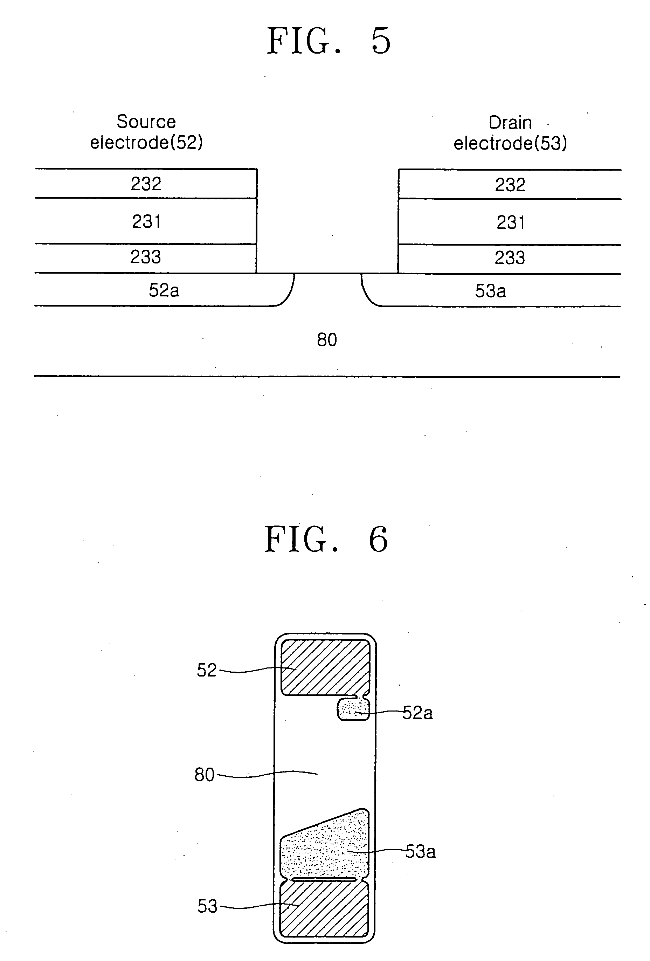

Turning now to FIGS. 5 and 6, FIG. 5 illustrates a cross section of a TFT after heat treatment using electrodes having pure aluminum and FIG. 6 is a top view of the TFT after heat treatment. FIG. 5 illustrates a semiconductor layer 80 arranged below and connected to S/D electrodes and lead lines 52 and 53, each of which has a three-layer structure of titanium (Ti) layer (thickness: 500Å) 232 /pure Al layer (thickness: 4,000Å) 231 /Ti layer (thickness: 500Å) 233, after heat treatment at 450°C. As illustrated in FIGS. 5 and 6, the Al of the pure Al layer 231 diffuses towards and into the semiconductor layer 80 when heat is applied to thereby form diffusion defect portions 52a and 53a in the semiconductor layer 80. The reason the Al of the pure Al layer 231 can diffuse towards and into the semiconductor layer 80 even though a Ti layer 233 is interposed between the pure Al layer 231 and the semiconductor layer 80 is that the Ti layer 233 is present in the form of a very thin film and/or there exists a Ti-free zone in Ti layer 233 according to the upper surface structure of the semiconductor layer 80. Thus, the presence of a thin titanium layer 233 between the pure aluminum layer 231 of the electrode and the semiconductor layer 80 of a TFT does not prevent aluminum from the pure aluminum layer 231 from diffusing into and destroying parts of semiconductor layer 80 when heat is applied. It is to be appreciated that the presence of a TiN diffusion layer between a titanium layer and a pure aluminum layer will not prevent aluminum from diffusing into the semiconductor layer 80 when heat is applied.

The resultant diffusion defect portions 52a and 53a may cause the same results as when pure aluminum is deposited directly onto the semiconductor layer 80. Defect portions 52a and 53a can prevent formation of a normal conductive channel between the source electrode and the drain electrode of a TFT. Furthermore, defect portions 52a and 53a may result in a short between the source electrode and the drain electrode, resulting in a malfunctioning TFT. Although FIGS. 5 and 6 illustrate the source 52 and the drain 53 electrodes of second TFT 50, the same applies to first TFT 10.

Hereinafter, the structures of S/D electrodes and lead lines will be described in detail with reference to FIGS. 2 and 7 through 10. According to this embodiment of the present invention, the first and second gate electrodes 11 and 53 are formed simultaneously with the second conductive line 30 using the same material. The first and second source electrodes 12 and 52, the first and second drain electrodes 13 and 53, the first conductive line 30, and the third conductive line 70 are at the same time formed using the same material. Since the formation sequences and materials for these conductive constitutional elements may vary according to manufacture processes, they are not limited to those described in this embodiment of the present invention.

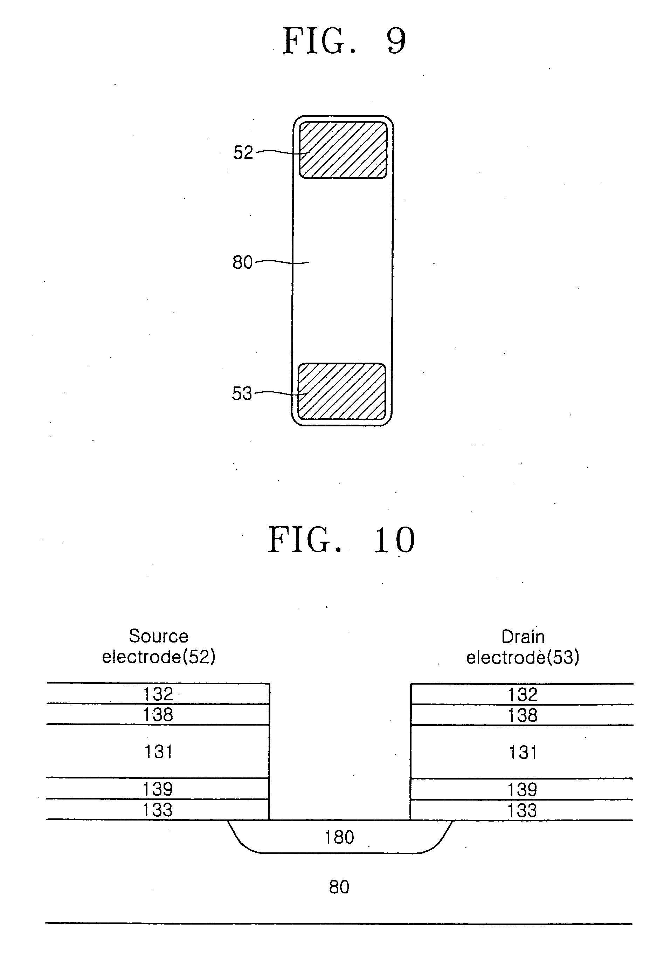

According to this embodiment of the present invention, at least one of S/D electrodes and lead lines 130 is made out of an aluminum (Al) alloy layer 131, and titanium (Ti) layers 132 and 133 formed on the respective upper and lower surfaces of the Al alloy layer 131. Optionally, in another embodiment illustrated in FIG. 10, diffusion prevention layers 138 and 139 made of titanium nitride (TiN), for example, may be interposed between the Al alloy layer 131 and the respective Ti layers 132 and/or 133. Aluminum diffusion can be prevented during a heat treatment when an aluminum alloy as opposed to pure aluminum is used in the electrode structure.

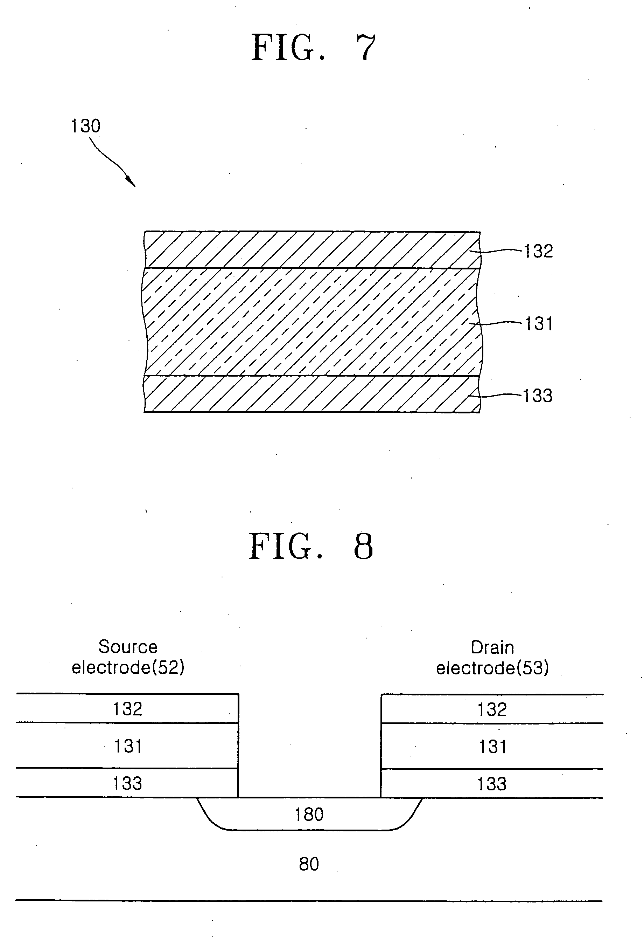

Preferably, the Al alloy layer 131 is made of an alloy that contains 0.1 to 5 wt%, preferably 2 wt% of at least one element selected from silicon (Si), copper (Cu), neodymium (Nd), platinum (Pt), and nickel (Ni). It has been determined empirically that when the S/D electrodes and lead lines according to this embodiment of the present invention as illustrated in FIG. 10 have a five layer structure of Ti layer (thickness: 250Å) 132 /TiN layer (thickness: 250Å) 138 /Al alloy layer (thickness: 4,000Å) 131 /TiN layer (thickness: 250Å) 139 /Ti layer (thickness: 250Å) 133, Al of the Al alloy layer 131 did not diffuse toward a semiconductor layer 80 even after a heat treatment process at 450°C. Therefore, the semiconductor layer 80 was kept clear of defect portions, as illustrated in FIG. 9, enabling a conduction channel 180 to form during TFT operation. These good results result from use of the Al alloy layer in the electrode structure and not using pure Al in the electrode structure. When the S/D electrodes and lead lines have a three layer structure of Ti layer (thickness: 500Å) 132 /Al alloy layer (thickness: 4,000Å) 131 /Ti layer (thickness: 500Å) 133 as illustrated in FIG. 8, the same result was obtained. In other words, the structure of FIG. 8, like the structure of FIG. 10, produced a semiconductor layer 80 as in FIG. 9 free from defect regions 52a and 53a.

It is to be appreciated that the empirical results of FIG. 9 were obtained under the same experiment conditions as the empirical results of FIG. 6 with the exception that the pure aluminum layer in the electrode stack is replaced with an aluminum alloy layer. In other words, the results of FIGS. 6 and 9 were obtained with all parameters held constant except for the substitution of an aluminum alloy layer 131 for the pure aluminum layer 231.

It is to be appreciated that titanium layers 132 and 133 are used instead of just an aluminum alloy layer 131 as the titanium layers 132 and 133 serve to prevent the formation of aluminum hillocks during heat treatment.

In another embodiment, a five layer electrode stack of FIG. 10 is employed where TiN diffusion prevention layers 138 (139) are interposed between each titanium layer 132 (133) and the aluminum alloy layer 131 to prevent the formation of unwanted TiAl₃ during a heat treatment process. TiAl₃ greatly increases the resistivity of the electrodes and the conductive lines. Therefore, TiN diffusion prevention layers 138 and 139 prevent TiAl₃ from forming thus keeping the resistivity of the electrodes and the conductive lines leading to the TFT low. This is particularly important in large flat panel displays where a low resistivity of electrodes and lead lines can prevent a non-uniform pixel display distribution. Although FIGS. 8, 9 and 10 have been discussed in conjunction with second TFT 50 having a source electrode 52 and a drain electrode 53, the novel structures of FIGS. 8, 9 and 10 equally apply to the first TFT 10 as well.

An optimum thickness of the TiN diffusion prevention layers 138 and 139 is 250Δ. If the thickness of the diffusion prevention layers are too thin, Al diffusion may occur, resulting in the formation of TiAl₃ during a heat treatment. On the other hand; if the TiN diffusion layers are too thick, the production cost becomes unnecessarily too high because of the unnecessarily thick TiN layers. Preferably, the TiN layers 138 and 139 contain 5 to 85 wt% of nitrogen.

In a method to make the electrode stack 130 of FIG. 10, the Al alloy layer 131 and the Ti layers 132 and 133 are deposited by DC-magnetron sputtering under an argon (Ar) gas atmosphere. The TiN layers 138 and 139 are deposited by reactive sputtering under a mixed gas atmosphere of Ar and nitrogen (N₂). Such a deposited structure is etched to a predetermined pattern for the S/D electrodes and lead lines by dry etching with high frequency-enhanced plasma.

It is to be appreciated that FIGS. 5 through 10 discuss second TFT 50 and second source electrode 52 and second drain electrode 53, FIGS. 5 through 10 and the concepts discussed in the discussion of FIGS. 5 through 10 above equally apply to the first TFT 10 having first source electrode 12 and first drain electrode 13.

The present invention provides a novel structure for an electrode attached to a semiconductor layer in a TFT that does not form defect regions in the semiconductor layer when exposed to a heat treatment. Furthermore, the resistivity is kept low. Other embodiments include the presence of titanium layers to prevent the formation of aluminum hillocks during heat treatment process. Further embodiments include the presence of a TiN diffusion layer between the aluminum alloy layer and the titanium layers to prevent the formation of highly resistive TiAl₃ during heat treatment. By employing the novel electrode structure of the present invention in a TFT transistor, the integrity of the transistor is maintained and the resistivity of the conductive lines and the electrodes are reduced allowing for the formation of large flat panel displays having uniform luminance between the pixels.

While the present invention has been particularly shown and described with reference to exemplary embodiments thereof, it will be understood by those of ordinary skill in the art that various changes in form and details may be made therein without departing from the spirit and scope of the present invention as defined by the following claims.

## Claims

1. A thin film transistor, comprising a source electrode, a drain electrode, a gate electrode and a semiconductor layer, wherein one of the source electrode, the drain electrode, and the gate electrode comprises an aluminum alloy layer disposed between a pair of titanium layers.

2. The thin film transistor of claim 1, wherein the aluminum alloy layer comprises about 0.1 to 5 wt% of at least one element selected from a group consisting of silicon, copper, neodymium, platinum and nickel.

3. The thin film transistor of claim 1, wherein a diffusion prevention layer is interposed between the aluminum alloy layer and each of the pair of titanium layers.

4. The thin film transistor of claim 3, wherein the diffusion prevention layer is made of titanium nitride.

5. The thin film transistor of claim 4, wherein the titanium nitride layer has a thickness between 100 and 500Å.

6. The thin film transistor of claim 4, wherein the titanium nitride layer contains 5 to 85 wt% of nitrogen.

7. The thin film transistor of claim 1, each electrode being absent of pure aluminum.

8. A flat panel display, comprising:
a substrate;
a first plurality of thin film transistors formed on a surface of the substrate, the first plurality of thin film transistors comprising first source electrodes, first drain electrodes, first gate electrodes, and semiconductor layers;
a plurality of first conductive lines electrically connected to the first source electrodes; and
a plurality of second conductive lines electrically connected to the first gate electrodes;
a second plurality of thin film transistors, wherein the first drain electrodes of the first plurality of thin film transistors are electrically connected to gate electrodes of the second plurality of thin film transistors, wherein one of the first source electrodes, the first drain electrodes, the first gate electrodes, the plurality of first conductive lines, and the plurality of second conductive lines comprises an aluminum alloy layer and a titanium layer formed on one surface of the aluminum alloy layer.

9. The flat panel display of claim 8, wherein the aluminum alloy layer comprises about 0.1 to 5 wt% of at least one element selected from the group consisting of silicon, copper, neodymium, platinum and nickel.

10. The flat panel display of claim 8, wherein a diffusion prevention layer is interposed between the aluminum alloy layer and the titanium layer.

11. The flat panel display of claim 10, wherein the diffusion prevention layer is made of titanium nitride.

12. The flat panel display of claim 11, wherein the titanium nitride layer has a thickness between 100 to 500Å.

13. The flat panel display of claim 11, wherein the titanium nitride layer contains 5 to 85 wt% of nitrogen.

14. A thin film transistor (TFT), comprising:
a source electrode, a gate electrode and a drain electrode; and
a semiconductor layer between the source electrode and the drain electrode, wherein one of said source electrode and said drain electrode contain an aluminum alloy layer and not a pure aluminum layer.

15. The TFT of claim 14, wherein the aluminum alloy layer comprises about 0.1 to 5 wt% of at least one element selected from the group consisting of silicon, copper, neodymium, platinum and nickel.

16. The TFT of claim 14, said aluminum alloy layer being bounded by a titanium layer.

17. The TFT of claim 14, said semiconductor layer being absent of aluminum after said TFT is subjected to a heat treatment of at least 300 degrees Celsius.

18. The TFT of claim 14, said semiconductor layer being primarily made of silicon and said semiconductive layer forming a conductive channel between said source electrode and said drain electrode upon application of a voltage to the gate electrode after said TFT is exposed to heat of at least 300 degrees Celsius.

19. The TFT of claim 14, said source electrode and said drain electrode both being formed of aluminum alloy and both being absent pure aluminum.

20. The TFT of claim 19, said source electrode and said drain electrode each comprising a TiN diffusion prevention layer between the aluminum alloy layer and each titanium layer.
